# EUROPEAN PATENT APPLICATION

(11) **EP 4 576 189 A1**
(43) Date of publication of application: **25.06.2025**
(21) Application number: 23220010.5
(22) Date of filing: 22.12.2023
(51) Int. Cl.: H01L 21/822, H01L 21/8234, H01L 27/06, H01L 27/088, H01L 29/06, H01L 29/66, H01L 29/775, H01L 21/02

(54) **A METHOD FOR FORMING A SEMICONDUCTOR STRUCTURE**

(71) Applicant: Imec VZW, 3001 Leuven (BE)
(72) Inventor: BIESEMANS, Serge, 3000 Leuven (BE); MERTENS, Hans, 3000 Leuven (BE); CHAN, Boon Teik, 3012 Wilsele (BE); HORIGUCHI, Naoto, 3000 Leuven (BE); BOEMMELS, Juergen, 3001 Heverlee (BE)
(74) Representative: AWA Sweden AB

(57) **Abstract**

A method for forming a semiconductor structure (100), the method comprising:
forming a layer stack (110);
forming a gate structure (250) on the layer stack;
forming at least one cavity (135) by removing the at least one second sacrificial layer (132b) of the layer stack (110);
depositing a first dielectric material (201), filling the at least one cavity (135) with the first dielectric material (201);
providing a dielectric free gate surface, free from the first dielectric material (201); and
depositing a second dielectric material (202) on the dielectric free gate surface, wherein the second dielectric material (202) is different from the first dielectric material (201).

## Description

### TECHNICAL FIELD

The present inventive concept relates, in general, to a semiconductor structure. In particular, it relates to a method for forming a semiconductor structure for a field effect transistor or a stack of field effect transistors.

### BACKGROUND

Modern semiconductor integrated circuit technology includes field effect transistors (FETs), for example nanowire FET (NWFET) and nanosheet FET (NSHFET). Further, FETs may be stacked on top of each other to form a stack of FETs. One notable example is a stack of FETs comprising a complementary pair of FETs stacked on top of each other, i.e. a p-type FET (PFET) on top of a n-type FET (FET), or vice versa. Such a stack of complementary FETs may be referred to as a CFET.

Dielectric material is used to electrically insulate one part of a FET from another part of the FET or to electrically insulate one FET from another FET.

### SUMMARY

It is an objective of the present inventive concept to facilitate semiconductor structures and/or FETs of high quality.

It is a further objective of the present inventive concept to facilitate semiconductor structures and/or FETs which are densely packed.

It is a further objective of the present inventive concept to facilitate FETs which are fast and/or operate at high frequencies.

It is a further objective of the present inventive concept to facilitate FETs with low parasitic capacitances.

These and other objectives of the inventive concept are at least partly met by the invention as defined in the independent claims. Preferred embodiments are set out in the dependent claims.

According to a first aspect there is provided a method for forming a semiconductor structure, the method comprising:
forming a layer stack on a substrate, the layer stack comprising:
   a first sub-stack comprising a first sacrificial layer and on the first sacrificial layer a channel layer defining a topmost layer of the first sub-stack;
   a second sub-stack on the first sub-stack and comprising a plurality of sacrificial layers alternating between first and second sacrificial layers, wherein first sacrificial layers define a respective bottommost and topmost layer of the second sub-stack, the second sub-stack comprising at least one second sacrificial layer;
   a third sub-stack on the second sub-stack and comprising a channel layer defining a bottommost layer of the third sub-stack and a first sacrificial layer on the channel layer;
   wherein the first sacrificial layers are formed of a first sacrificial semiconductor material, the second sacrificial layers are formed of a second sacrificial semiconductor material different from the first sacrificial semiconductor material,
forming a gate structure on the layer stack;
forming at least one cavity by removing the at least one second sacrificial layer of the second sub-stack;
depositing a first dielectric material, wherein said act of depositing the first dielectric material comprises filling the at least one cavity with the first dielectric material;
providing a dielectric free gate surface, the dielectric free gate surface being an end surface of the gate structure, free from the first dielectric material; and
depositing a second dielectric material on the dielectric free gate surface, wherein the second dielectric material is different from the first dielectric material;
wherein said act of depositing the second dielectric material is performed after said act of depositing the first dielectric material.

By the term "layer stack" is hereby meant a structure of layers, sequentially formed on top of each other. The device layer stack may in particular be fin-shaped.

The first sub-stack designates a first subset of consecutive layers of the layer stack, the second sub-stack designates a second subset of consecutive layers of the layer stack, the third sub-stack designates a third subset of consecutive layers of the layer stack.

By the wording "a first layer on a second layer" in reference to any of the layers (or sub-stacks) of the layer stack is hereby meant, unless stated otherwise, that the first layer is arranged directly on (i.e. in abutment with) the second layer.

Relative spatial terms such as "topmost", "bottom", "lower", "vertical", "stacked on top of", are herein to be understood as denoting locations or directions within a frame of reference of the semiconductor device. In particular, the terms may be understood in relation to a normal direction to the substrate on which the device layer stack is formed, or equivalently in relation to a bottom-up direction of the device layer stack. Correspondingly, terms such as "lateral" and "horizontal" are to be understood as locations or directions parallel to the substrate.

The term "thickness" is to be understood as a dimension of a structure (e.g. a layer of a sub-stack) as seen along a normal to a surface underlying the structure (e.g. the layer of the sub-stack). For example, the thickness of a layer of the device layer stack, or the thickness of the second sub-stack, may refer to the thickness dimension of the layer/sub-stack as seen along the bottom-up direction of the device layer.

The semiconductor structure may be a semiconductor structure for producing a stack of field effect transistors (FETs) comprising a top and bottom FET. The stack of FETs may be CFET, wherein the top FET is a NFET and the bottom FET is a PFET, or vice versa. Thus, the semiconductor structure may be a semiconductor structure suitable to be converted into a stack of FETs, e.g. a CFET.

The layer stack may be a layer stack for producing a stack of FETs.

Channel layers of the first sub-stack may be channel layers for a bottom FET. Similarly, channel layers of the third sub-stack may be channel layers for a top FET. Accordingly, channel layers may be channel layers for a FET. Channel layers may be Si layers.

First sacrificial layers may be layers that can be replaced with a gate stack during production of a stack of FETs.

Second sacrificial layers are layers that are replaced with first dielectric material during production of a stack of FETs. The first dielectric material may then function as electrical isolation between the bottom and top FET. Such electrical isolation between the bottom and top FET may be referred to as middle dielectric isolation.

A material of the channel layers may be Si₁₋ₐGeₐ, the first sacrificial semiconductor material may be Si_{1-c}Ge_{c}, and the second sacrificial semiconductor material may be Si_{1-d}Ge_{d}, wherein 0 ≤ a < c < d. To exemplify:
a may be below 0.05, typically a=0;
c may be in the range of 0.1-0.25;
d may be in the range of 0.35-0.5.

An exemplary material choice is:
The material of channel layers is Si;
the first sacrificial semiconductor material is Si_{0.8}Ge_{0.2};
the second sacrificial semiconductor material is Si_{0.6}Ge_{0.4}.

The channel layers may be layers of silicon (as indicated above). The first and third sub-stack may respectively comprise a single channel layer or a plurality of channel layers, e.g. at least two channel layers.

Neighboring channel layers of the first sub-stack may be separated by a first sacrificial layer. Thus, the first sub-stack may comprise a number of repeats of a first sub-stack unit, the first sub-stack unit comprising a first sacrificial layer and on the first sacrificial layer a channel layer. To exemplify, two repeats may be, from bottom to top: first sacrificial layer/channel layer/first sacrificial layer/channel layer.

Neighboring channel layers of the third sub-stack may be separated by a first sacrificial layer. Thus, the third sub-stack may comprise a number of repeats of a third sub-stack unit, the third sub-stack unit comprising a channel layer and on the channel layer a first sacrificial layer. To exemplify, two repeats may be, from bottom to top: channel layer/first sacrificial layer/channel layer/first sacrificial layer.

The semiconductor structure may be seen as extending between two ends. When the stack of FETs is finished, source regions may be arranged at one end and drain regions may be arranged at the other end, in a direction perpendicular to a gate structure.

As mentioned, the second sub-stack comprises a plurality of sacrificial layers alternating between first and second sacrificial layers, wherein first sacrificial layers define the respective bottommost and topmost layer of the second sub-stack.

For example, the second sub-stack may comprise a first sacrificial layer as bottommost layer and a first sacrificial layer as topmost layer, with a single second sacrificial layer therebetween. This would correspond to the situation where the second sub-stack comprises solely one second sacrificial layer.

However, the second sub-stack may comprise a plurality of second sacrificial layers, e.g. at least two second sacrificial layers or at least three second sacrificial layers, each separated by a respective first sacrificial layer.

Thus, the method may be configured such that the second sub-stack comprises at least two second sacrificial layers, such that at least two cavities are formed and filled with the first dielectric material.

To exemplify, a second sub-stack comprising exactly two second sacrificial layers may correspond to the following layer sequence, from bottom to top: first sacrificial layer/second sacrificial layer/first sacrificial layer/second sacrificial layer/first sacrificial layer. A second sub-stack comprising at least two second sacrificial layers is advantageous as it provides good electrical isolation between the top and bottom FET. It may be advantageous to use a second sub-stack comprising a plurality of thin second sacrificial layers rather than a second sub-stack comprising one thick second sacrificial layer. Lattice mismatch between first and second sacrificial layers may cause dislocations if a thick second sacrificial layer is used.

The plurality of sacrificial layers alternating between first and second sacrificial layers may also be expressed as the plurality of sacrificial layers switching between first and second sacrificial layers.

The gate structure may be a sacrificial gate body. Such a sacrificial gate body may be replaced by a gate stack later during the production of the stack of FETs. The sacrificial gate body may comprise amorphous silicon. Further, first sacrificial layers may also be replaced by the gate stack.

Alternatively, the gate structure may be part of the final gate of the stack of FETs.

As mentioned earlier, the semiconductor structure may be seen as extending between two ends. The layer stack of the semiconductor structure may be fin-shaped. Thus the two ends may be ends of the fin-shaped layer stack. A direction between the two ends of the semiconductor structure may be perpendicular to the gate structure. A direction between the two ends of the semiconductor structure may be parallel to the fin-shaped layer stack. Thus, the gate structure may also have two ends. One end surface of the gate structure may be a surface (e.g. a vertical surface) facing what will become the source region at the end of the production of the stack of FETs. Another end surface of the gate structure may be a surface (e.g. a vertical surface) facing what will become the drain region at the end of the production of the stack of FETs. Accordingly, an end surface of the gate structure may be a surface in a vertical plane.

Removing the at least one second sacrificial layer of the second sub-stack may be performed by selective etching, e.g. etching selectively to the other layers of the layer stack. Thus, the other layers of the layer stack may remain when the at least one second sacrificial layer of the second sub-stack is removed.

Depositing the first dielectric material, to fill the at least one cavity with the first dielectric material, may be performed by various deposition methods. For example, depositing the first dielectric material may be performed by atomic layer deposition (ALD), such as plasma enhanced ALD (PEALD). Alternatively, depositing the first dielectric material may be performed by chemical vapor deposition (CVD). For example, a first CVD method may be used. The first CVD method is discussed further below.

The dielectric free gate surface may be provided in various ways, the dielectric free gate surface being an end surface of the gate structure, free from the first dielectric material

A first way of providing a dielectric free gate surface may be to remove first dielectric material from said gate surface. As will be described further below, when the first dielectric material is deposited, there may also be first dielectric material deposited on the gate structure. In this case, the dielectric free gate surface may be provided by removing first dielectric material from the end surface of the gate structure.

A second way of providing a dielectric free gate surface may be to deposit first dielectric material by a method which does not deposit on said gate surface. As will be described further below, the first dielectric material may be deposited preferentially in the at least one cavity, such that no first dielectric material is deposited on the end surface of the gate structure. For example, the first CVD method may be used to preferentially deposit first dielectric material in the at least one cavity.

As mentioned, the second dielectric material is deposited on the dielectric free gate surface. Further, the second dielectric material is different from the first dielectric material. The second dielectric material deposited on the dielectric free gate surface may function as a gate spacer in the finished device.

Depositing the second dielectric material may be performed by atomic layer deposition.

It is a realization that it is advantageous to use different dielectric materials within the layer stack and on the end surfaces of the gate structure. Accordingly, in the finished stack of FETs, the middle dielectric isolation may comprise one dielectric material (first dielectric material) while the gate spacer comprises another dielectric material (second dielectric material). There may be various factors to consider with regards to dielectric material. One factor may be the capacitance between the components separated by the dielectric material. Said capacitance may relate to the dielectric constant of said dielectric material. Another factor may be surface states between the dielectric material and the surface on which it is arranged. Another factor may be the amount of voids in the dielectric constant. It is a realization that the factors constraining middle dielectric isolation dielectric material may be different from the factors constraining gate spacer dielectric material. By the use of the method of the invention, middle dielectric isolation dielectric material and gate spacer dielectric material may be individually tailored.

To exemplify, it is a realization that it may be advantageous to use a gate spacer with low dielectric constant. Accordingly, the second dielectric material may have a low dielectric constant. This may also be expressed as the second dielectric material being low-k material. This may reduce parasitic capacitances. Thereby, FETs which are fast and/or operate at high frequencies are facilitated. Further, the FETs may be more densely packed if the parasitic capacitances are reduced.

For example, the second dielectric material may have a dielectric constant below 6.5. This may provide low parasitic capacitances. It should be understood that the second dielectric material may have an even lower dielectric constant. Accordingly, the second dielectric material may have a dielectric constant below 6, or below 5.5, or below 5, or below 4.5.

The second dielectric material may comprise SiOCN and/or SiOC. Such materials may have a low dielectric constant and benefit from the advantages above. Further, such materials may be hard and durable. The above materials may be deposited e.g. by ALD.

The first dielectric material may e.g. be or comprise SiN, a material very compatible with the production of stacks of FET and for which there are many suitable methods for deposition and etching. Alternatively, the first dielectric material may be or comprise SiOC or SiOCN or SiCN. The above materials may be deposited e.g. by ALD. Alternatively, The above materials may be deposited by the first CVD method.
In the following, the first way of providing a dielectric free gate surface will be discussed.

The method may be configured such that the first dielectric material is deposited also on the end surface of the gate structure during said act of filling the at least one cavity with the first dielectric material;
wherein said act of forming the dielectric free gate surface comprises removing first dielectric material from the end surface of the gate structure.

Removing first dielectric material from the end surface of the gate structure may e.g. be performed by dry isotropic etching. Dry isotropic etching allows first dielectric material to be etched at a uniform rate (at least substantially). Further, such etching may also be used for other steps in the process of manufacturing a stack of FETs, e.g. during formation of inner spacers. Thus, dry isotropic etching may be easily available.

After removing first dielectric material from the end surface of the gate structure, the second dielectric material may be deposited.

In the following, the second way of providing a dielectric free gate surface will be discussed. Herein, the first dielectric material is deposited in the at least one cavity without depositing on the gate surface. A suitable method for doing so is the first CVD method.

Accordingly, the method for forming the semiconductor structure may be configured such that said act of depositing the first dielectric material is performed by a first chemical vapor deposition method, CVD method, the first CVD method comprising:
reacting, as a film-forming gas, an oxygen-containing silicon compound gas with a non-oxidizing hydrogen-containing gas in a state in which at least the non-oxidizing hydrogen-containing gas is plasmarized, to form a film of a flowable silanol compound; and
subsequently, annealing the film of flowable silanol compound into the first dielectric material,
wherein the oxygen-containing silicon compound gas comprises Si_{α}O_{β}(O-CₘHₙ)┌CₓH_{y}, wherein m, n, and α are integers of 1 or more; and wherein β, Γ, x, and y are integers of 0 or more; and β and Γ are not 0 at the same time.

The first CVD method is described in patent publication US20220235456A1 , which is hereby incorporated by reference. In particular, the detailed description of US20220235456A1 is incorporated by reference.

The first CVD method may be called Ultra Chemical Vapor Deposition (UCVD) or Chemical Vapor Liquid Deposition. In the following description the term UCVD will primarily be used.

The UCVD method may primarily deposit material in cavities and/or trenches. Thus, the dielectric material may primarily be deposited in the cavity formed by removing the second sacrificial layer. Thus, the end surface of the gate structure may be free from first dielectric material after the deposition of first dielectric material.

The UCVD method has further advantages. Dielectric material deposited by the UCVD method may have a flat profile. It may in this context be noted that by flat profiles it is generally meant that end surfaces of the dielectric material may have little or no rounding. The rounding of corners of the end surfaces may sometimes be referred to as curving. The provision of such flat profile dielectric material may enable a reduction of processing steps since separate steps such as pre-cleaning may not be needed. The reduction of pre-cleaning steps may enable a reduction of erosion of the dielectric layers/sacrificial layer, or any other layers of the layer stack that would normally be subjected to erosion. Further, the UCVD method may provide dielectric material compound with few voids, e.g. void free dielectric material, and thereby there may be provided high quality dielectric material.

The method may further comprise:
removing, by vertical recessing, ends of the layer stack and second dielectric material on said ends;
subsequently, laterally recessing end surfaces of the first sacrificial layers of the layer stack to form recesses; and
forming inner spacers in the recesses.

By the term "inner spacers" is hereby meant dielectric layer portions formed in the recesses to cover end surfaces of the first sacrificial layers. The vertical recessing may be source/drain recessing. The vertical recessing may be performed by anisotropic etching, e.g. dry anisotropic etching. Laterally recessing end surfaces of the first sacrificial layers of the layer stack may be performed by an isotropic etching process. Forming the inner spacers may comprise depositing inner spacer material layer with a thickness such that the recesses are pinched-off (i.e. closed). The inner spacer material may be conformally deposited, e.g. by ALD.

The method for forming the semiconductor structure may comprise further steps towards a finished stack of FETs.

In the case the gate structure is a sacrificial gate body, the method may further comprise:
replacing the sacrificial gate body with a gate stack.

The method may comprise:
forming source/drain regions at opposite ends of the channel layers of the first sub-stack; and
forming source/drain regions at opposite ends of the channel layers of the third sub-stack;
such that the semiconductor structure forms a stack of field effect transistors, FETs, comprising:
   a first FET, comprising the channel layer of the first sub-stack; and
   a second FET, comprising the channel layer of the second sub-stack.
It is further a realization that liner layers may advantageously be used. Thus, the method may be configured such that neighboring first and second sacrificial layers of the second sub-stack are separated by a liner layer, the liner layers of the second sub-stack being formed of a semiconductor material different from the first and second sacrificial semiconductor materials.

The liner layers may be layers resistant to the etchant used to etch the second sacrificial layers. The liner layers may be layers resistant to the etchant used to recess the first sacrificial layers. The liner layers may be thin, e.g. thinner than the first and second sacrificial layers.

As mentioned, the first and second sacrificial layers are formed of different semiconductor materials. Thus, etchants may have different etch rates for the first and second sacrificial layers. Thus, the first and second sacrificial layers may be selectively etched at different points in the production process, or should they be etched at the same time, they will be etched a different amount. The channel layers, liner layers, first sacrificial layers and second sacrificial layers may all be of different materials. Alternatively, channel layers and liner layers are formed of the same material, different from the first and second sacrificial semiconductor materials. Advantageously, channel layers and liner layers are formed of Si and first and second sacrificial layers are formed of SiGe, wherein first and second sacrificial layers have different Ge composition.

Due to the liner layers, rounding of corners of the first sacrificial layers may be avoided, even if the etching of end surfaces of the first sacrificial layers is done isotropically. In other words, the employment of liner layers enables isotropic selective etching while avoiding rounding of corners of the first sacrificial layers. As first sacrificial layers may later be replaced by a gate stack, the use of liner layers may facilitate a well defined gate stack.

Due to the liner layers, a smaller difference in composition between first and second sacrificial layers may be used than if no liner layers are present. For example, the difference in Ge composition between first and second sacrificial layers may be small when liner layers are used. Even if the etch selectivity is small when the difference in Ge composition is small, the liner layers may help to protect the first sacrificial layers during removal of the second sacrificial layers. A small difference in composition between first and second sacrificial layers may reduce strain related problems, e.g. strain related formation of dislocations.

According to a second aspect there is provided a semiconductor structure, comprising:
a layer stack, comprising:
   a first sub-stack comprising a first sacrificial layer and on the first sacrificial layer a channel layer defining a topmost layer of the first sub-stack;
   a second sub-stack on the first sub-stack and comprising a plurality of layers alternating between first sacrificial layer and layer of first dielectric material, wherein first sacrificial layers define a respective bottommost and topmost layer of the second sub-stack;
   a third sub-stack on the second sub-stack and comprising a channel layer defining a bottommost layer of the third sub-stack and a first sacrificial layer on the channel layer;
   wherein the first sacrificial layers are formed of a first sacrificial semiconductor material;
a gate structure arranged on the layer stack;
a second dielectric material arranged on an end surface of the gate structure;
wherein the second dielectric material is different from the first dielectric material.

A device according to the second aspect may have the same advantages, or similar advantages, as the advantages described in conjunction with the first aspect.

In accordance with the discussion regarding the method of the first aspect, the second dielectric material of the device may have a dielectric constant below 6.5.. For example, the second dielectric material may have a dielectric constant below 6, or below 5.5, or below 5, or below 4.5.

### BRIEF DESCRIPTION OF THE DRAWINGS

The above, as well as additional objects, features and advantages of the present inventive concept, will be better understood through the following illustrative and non-limiting detailed description, with reference to the appended drawings. In the drawings like reference numerals will be used for like elements unless stated otherwise.
Fig. 1a-g illustrate a method for forming a semiconductor structure, according to some embodiments.
Fig. 2a-b to 8a-b illustrate optional further steps towards a finished stack of FETs.
Fig. 9a-c illustrate the use of liner layers.

### DETAILED DESCRIPTION

In cooperation with attached drawings, the technical contents and detailed description of the present invention are described thereinafter according to a preferable embodiment, being not used to limit the claimed scope. This invention may be embodied in many different forms and should not be construed as limited to the embodiments set forth herein; rather, these embodiments are provided for thoroughness and completeness, and fully convey the scope of the invention to the skilled person.

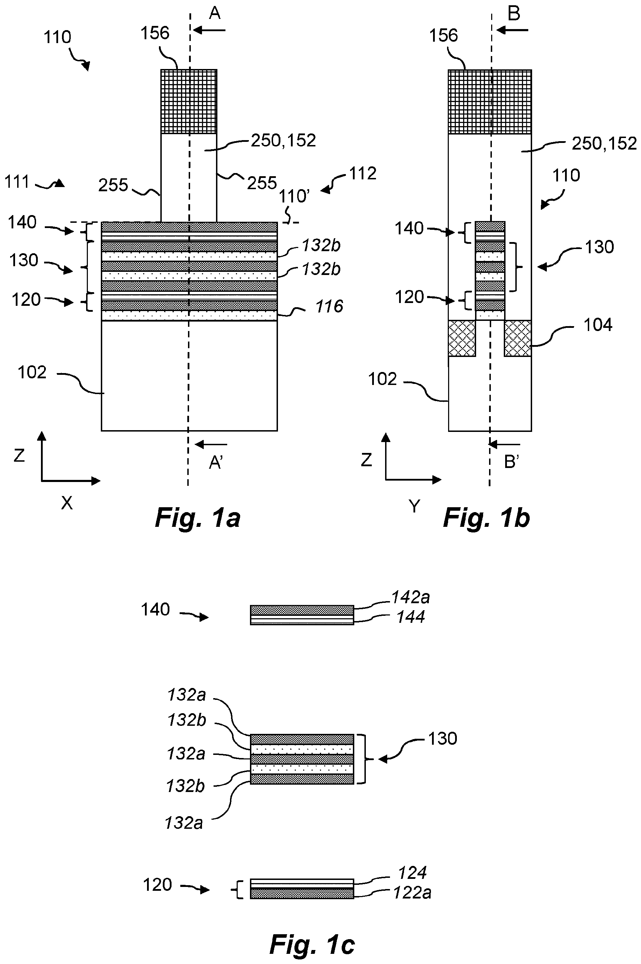

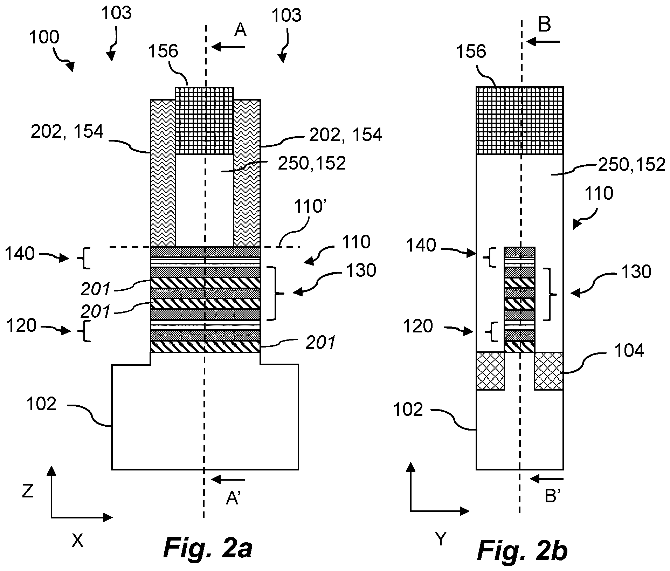

Figs. 1a-g illustrate one implementation of the method for forming a semiconductor structure. Fig. 2a-b to 8a-b illustrate optional further steps towards a finished stack of FETs.

Axes X, Y and Z indicate a first direction, a second direction transverse to the first direction, and a vertical or bottom-up direction, respectively. The X- and Y-direction may in particular be referred to as lateral or horizontal directions in that they are parallel to a main plane of a substrate 102 of the structure 100. The Z-direction is parallel to a normal direction to the substrate 102.

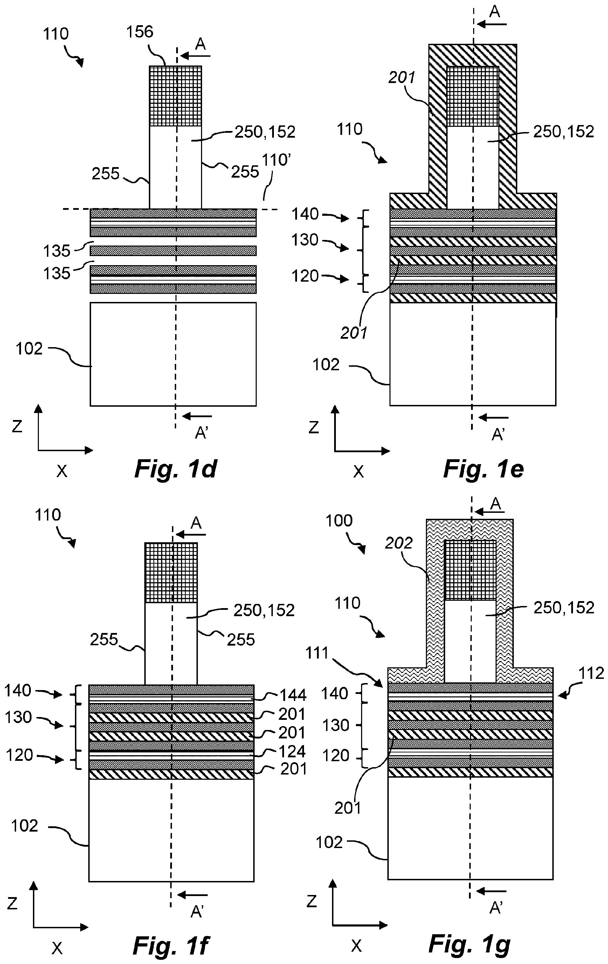

Fig. 1a-b depict respective cross-sectional views of the layer stack 110 taken along vertical planes B-B' (parallel to the XZ-plane) and A-A' (parallel to the YZ plane). Fig. 1c is a schematic illustration of the first, second, and third sub-stacks. The cross-sectional views of Fig. 1d-g correspond to that of Fig. 1a unless stated otherwise, i.e. along vertical planes B-B'. The layer stack 110 has a first end 111 and a second end 112, as illustrated in Fig. 1a.

The layer stack 110 is arranged on a substrate 102. The substrate 102 may be a conventional semiconductor substrate suitable for complementary FETs. The substrate 102 may be a single-layered semiconductor substrate, for instance formed by a bulk substrate such as a Si substrate, a germanium (Ge) substrate or a silicon-germanium (SiGe) substrate. A multi-layered / composite substrate is however also possible, such as an epitaxially grown semiconductor layer on a bulk substrate, or a semiconductor-on-insulator (SOI) substrate, such as a Si-on-insulator substrate, a Ge-on-insulator substrate, or a SiGe-on-insulator substrate.

The layer stack 110 comprises a first sub-stack 120, a second sub-stack 130 on the first sub-stack 120, and a third sub-stack 140 on the second sub-stack 130.

Fig. 1c depicts the first sub-stack 120 (bottom), the second sub-stack 130 (middle) and the third sub-stack 140 (top) in isolation for illustrational clarity.

The first sub-stack 120 comprises a first sacrificial layer 122a and a channel layer 124 on the first sacrificial layer 122a. The channel layer 124 forms a top (i.e. topmost) layer of the first sub-stack 120. The layers 122a and 124 may be referred to as one unit of the first sub-stack 120. Although Fig. 1c depicts merely one such unit (i.e. a single) of the first sub-stack 120, it is to be understood that the first sub-stack 120 may comprise more than merely a single unit. For instance, the first sub-stack 120 may e.g. comprise two, three, or four etc. units. As such, the first sub-stack 120 may comprise two, three, or four etc. first sacrificial layers 122a and channel layers 124, respectively. In case the first sub-stack 120 comprises a plurality of such units, said units may be consecutively arranged. For instance, the units may be arranged on top of each other.

The second sub-stack 130 comprises a plurality of sacrificial layers alternating between first and second sacrificial layers 132a, 132b.

Fig. 1c illustrates a second sub-stack 130 comprising (along a bottom-up direction) a bottommost first sacrificial layer 132a, a second sacrificial layer 132b, a first sacrificial layer 132a, a second sacrificial layer 132b, and a topmost first sacrificial layer 132a. The bottommost first sacrificial layer 132 is thus arranged on the first sub-stack 120, i.e. on the channel layer 124. Although Fig. 1c depicts merely two second sacrificial layers 132b of the second sub-stack 130, it is to be understood that the second sub-stack 130 may comprise more than merely two second sacrificial layers 132b. It is also conceivable that the second sub-stack 130 may comprise one (i.e. a single) second sacrificial layer 132b.

The third sub-stack 140 comprises a channel layer 144 and a first sacrificial layer 142a on the channel layer 144. The channel layer 144 forms a bottom (i.e. bottom-most) layer of the third sub-stack 140. The channel layer 144 is thus arranged on the second sub-stack 130, i.e. on the topmost first sacrificial layer 132a. The layers 144 and 142a may be referred to as one unit of the third sub-stack 140. Although Fig. 1c depicts merely one such unit (i.e. a single) of the third sub-stack 140, it is to be understood that the third sub-stack 140 may comprise more than merely a single unit. For instance, the third sub-stack 140 may e.g. comprise two, three, or four etc. units. As such, the third sub-stack 140 may comprise two, three, or four etc. first sacrificial layers 142a and channel layers 144, respectively. In case the third sub-stack 140 comprises a plurality of such units, said units may be consecutively arranged. For instance, the units may be arranged on top of each other.

The first sacrificial layers of the first through third sub-stacks 120, 130, 140 (122a, 132a, 142a) and the second sacrificial layers of the first through third sub-stacks 120, 130, 140 may be formed with a uniform or at least similar thickness. It is also conceivable that the second sacrificial layers may be formed with a greater thickness than each of the first sacrificial layers of the first through third sub-stacks 120, 130, 140 (122a, 132a, 142a). The total thickness of the second sub-stack 130 may accordingly exceed a thickness of each first sacrificial layer of the first sub-stack 120 and the third sub-stack 140.

The channel layers of the first and third sub-stacks 120, 140 may also be of a uniform or at least similar thickness, e.g. a different or a same thickness as the first sacrificial layers of the layer stack 110.

By way of example, the channel layers of the first and third sub-stacks 120, 140 may each be formed with a thickness of 3-10 nm, the first sacrificial layers of the first through third sub-stacks 120, 130, 140 (122a, 132a, 142a) may each be formed with a thickness of 3-10 nm, the second sacrificial layers 132b may be formed with a thickness of 5-30 nm. The total thickness of the second sub-stack 130 may for example be 20-50 nm.

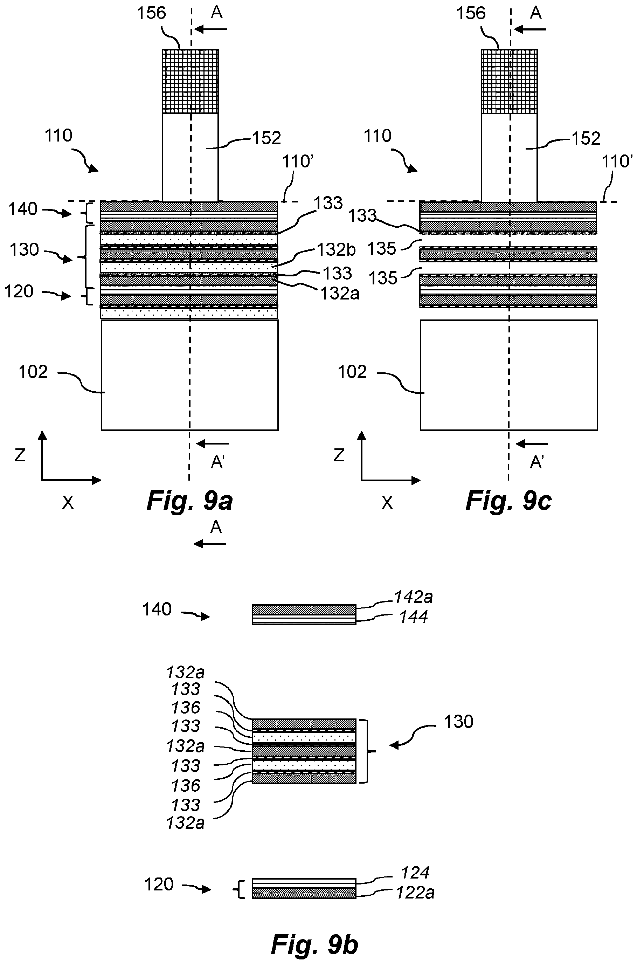

The material of the channel layers may be Si₁₋ₐGeₐ, the first sacrificial material may be Si_{1-c}Ge_{c}, and the second sacrificial material may be Si_{1-d}Ge_{d}, wherein 0 ≤ a < c < d. For example, c may be in a range of 0.1-0.25. Further, d may be in a range of 0.35-0.5. In a more specific example, the channel material may be Si (i.e. a = 0), the first sacrificial material may be Si_{0.75}Ge_{0.25}, and the second sacrificial material may be Sio.sGeo.s. These relative differences in Ge-content facilitate a selective processing (e.g. selective etching) of the different sacrificial layers and the channel layers of the layer stack 110 (and the liner layers discussed in conjunction with Fig. 9).

The layers of the device layer stack 110 may each be epitaxial layers, e.g. epitaxially grown using deposition techniques which per se are known, such as chemical vapor deposition (CVD) or physical vapor deposition (PVD). This enables high quality material layers with an advantageous degree of control of composition and dimensions.

The deposited layers may be sequentially formed and subsequently patterned to define an elongated fin-shaped layer stack, extending in the X-direction. The dashed line 110' schematically indicates a contour of the layer stack 110 subsequent to fin patterning and prior to fin recess, described below. While the figures depict only a single layer stack, it is to be understood that a plurality of parallel fin-shaped layer stacks may be formed. Conventional fin patterning techniques may be used, e.g. single patterning techniques such as lithography and etching ("litho-etch") or multiplepatterning techniques such as (litho-etch)x, self-aligned double or quadruple patterning (SADP or SAQP).

The layers of the layer stack 110 may each be formed as nanosheets, e.g. with a width (along Y) to thickness (along Z) ratio greater than 1, such as a width in a range from 10 nm to 30 nm and a thickness in a range from 3 nm to 10 nm. It is also possible to pattern the layer stacks such that the channel layers form nanowire-shaped layers. A nanowire may by way of example have a thickness similar to the example nanosheet however with a smaller width, such as 3 nm to 10 nm.

As shown in Figs. 1a-b, subsequent to the fin patterning, a lower portion of the device layer stack 110 may be surrounded by a shallow trench isolation (STI) 104, e.g. of SiO₂.

As further shown in Figs. 1a-b, a gate structure 250 in the form of a sacrificial gate body 152 may be formed to extend across the layer stack 110. The gate structure 250 comprises two end surfaces 255, as illustrated. The sacrificial gate body 250, 152 may be formed by depositing a sacrificial gate body material (e.g. amorphous Si) over the layer stack 110 and subsequently patterning the sacrificial gate body 250, 152 therein. While the figures depict only a sacrificial gate body 250, 152, it is to be understood that a plurality of parallel sacrificial gate structures may be formed across the layer stack 110. Conventional patterning techniques may be used, e.g. single patterning techniques such as lithography and etching ("litho-etch") or multiplepatterning techniques such as (litho-etch)x, SADP or SAQP.

On-top of the sacrificial gate body 250, 152 there may be a capping layer 156, e.g. formed of one or more layers of hardmask material remaining from the sacrificial gate body patterning.

As shown in Fig. 1a-b, the layer stack 110 may also comprise a bottom second sacrificial layer 116. The bottom second sacrificial layer 116 may be arranged between the substrate 102 and the first sub-stack 120.

The bottom second sacrificial layer 116 may be subject to the same processing steps as the second sacrificial layers 132b of the second sub-stack 130 (and the first sacrificial layers of the sub-stacks 120, 130, 140).

During the manufacturing process, the bottom second sacrificial layer 116 may be replaced with dielectric material, e.g. replaced with first dielectric material 201, as will be shown later. The dielectric material replacing the bottom second sacrificial layer 116 may form a bottom dielectric isolation for the finished stack of FETs.

The use of bottom dielectric isolation is optional. Hence, the use of a bottom second sacrificial layer 116 is optional.

Fig. 1d shows the removal of the second sacrificial layers 132b of the second sub-stack 130. In Fig. 1d, the second sacrificial layers 132b of the second sub-stack 130 have been removed by selectively etching the second sacrificial semiconductor material, thereby forming cavities 135 in the second sub-stack 130. The second sacrificial semiconductor material may be etched using an isotropic etching process (wet or dry), to laterally etch back end surfaces of the second sacrificial layers 132b from opposite ends of the layer stack 110. For example, an HCl-based dry etch may be used to remove second sacrificial layer material, e.g. remove second sacrificial material having higher Ge-content than the first sacrificial material. However, other appropriate etching processes (e.g. wet etching processes) are also known in the art and may also be employed for this purpose.

After forming the cavities 135, first dielectric material 201 is deposited to fill the cavities 135. First dielectric material 201 having a dielectric constant below 6.5 may be used. The first dielectric material 201 may be or comprise e.g. SiN, or SiOC or SiOCN or SiCN.

The first dielectric material 201 may be deposited to fill the cavities 135 and also cover end surfaces 255 of the gate structure 250, as illustrated in Fig. 1e. In this case, the dielectric free gate surface may be provided by removing first dielectric material 201 from the end surfaces 255 of the gate structure 250, as illustrated in Fig. 1f. This corresponds to the first way of providing a dielectric free gate surface, discussed above.

Alternatively, the first dielectric material 201 may be deposited by a method which does not deposit on the end surfaces 255 of the gate structure 250. In such a case, the situation illustrated in Fig. 1e may not arise. Instead, the layer stack 110 may look as illustrated in Fig. 1f directly after deposition of the first dielectric material 201, without any need for removing first dielectric material 201 from the end surfaces 255 of the gate structure 250. This corresponds to the second way of providing a dielectric free gate surface, discussed above.

In the first way of providing a dielectric free gate surface, the first dielectric material 201 may be deposited by a conformal deposition method, e.g. ALD. Alternatively, the first dielectric material 201 may be deposited by the first CVD method discussed below.

In the second way of providing a dielectric free gate surface, the first dielectric material 201 may be deposited by a deposition method configured to preferentially deposit in cavities 135. Such a deposition method may be the first CVD method.

The first CVD method may comprise:
reacting, as a film-forming gas, an oxygen-containing silicon compound gas with a non-oxidizing hydrogen-containing gas in a state in which at least the non-oxidizing hydrogen-containing gas is plasmarized, to form a film of a flowable silanol compound; and
subsequently, annealing the film of flowable silanol compound into the first dielectric material,
wherein the oxygen-containing silicon compound gas comprises Si_{α}O_{β}(O-CₘHₙ)┌CₓH_{y}, wherein m, n, and α are integers of 1 or more; and wherein β, Γ, x, and y are integers of 0 or more; and β and Γ are not 0 at the same time.

If first dielectric material 201 has been deposited on the end surfaces 255 of the gate structure 250, it may be removed by etching. For example, any suitable isotropic etching process (wet or dry) for etching the dielectric material (e.g. SiN).

Fig. 1g illustrates a second dielectric material 202 being deposited on the dielectric free gate surface. The second dielectric material 202 is herein different from the first dielectric material 201. The second dielectric material 202 may be deposited by a conformal deposition method, e.g. ALD. The second dielectric material 202 may comprises SiOCN and/or SiOC. The second dielectric material 202 may, as illustrated, also cover ends 111,112 of the layer stack 110.

In the following, optional further steps towards a finished stack of FETs will be discussed, in conjunction with Fig. 2a-b to 8a-b. Figs. 2a-b depict respective cross-sectional views of the layer stack 110 taken along vertical planes B-B' (parallel to the XZ-plane) and A-A' (parallel to the YZ plane). The cross-sectional views of the subsequent figures correspond to those in Figs. 2a-b unless stated otherwise.

Fig. 2a-b illustrate that ends 111,112 of the layer stack 110 may be removed by vertical recessing. Thus, vertical recesses 103 are formed, these may be called source/drain recesses 103. The vertical recessing may be performed by anisotropic etching, e.g. dry anisotropic etching. The second dielectric material 202 covering ends 111,112 of the layer stack 110 may, as illustrated, also be removed by the vertical recessing.

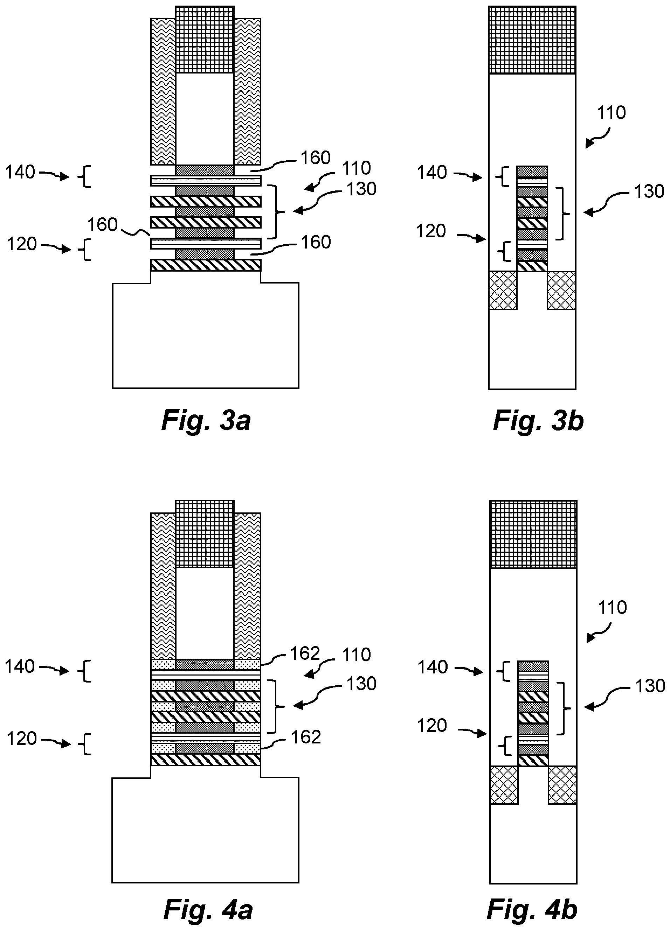

Fig. 3a-b show that subsequently to forming source/drain recesses 103 end surfaces of the first sacrificial layers 122a, 132a, 142a of the layer stack 110 may be laterally recessed to form recesses 160.

In Fig. 3a, recesses 160 have been formed in the layer stack 110 by laterally etching back (e.g. along the X- and negative X-direction) end surfaces of each first sacrificial layer of the layer stack 110 from opposite ends of the layer stack 110, by selective etching. The lateral etch back may be achieved by an isotropic etching process. Any suitable dry etching process or wet etching process allowing selective etching of the first sacrificial material may be used (e.g. HCl, or APM). As indicated in Fig. 3a, the extent of the lateral etch back may correspond to a thickness of the first dielectric material 201 on the respective end surfaces 255 of the gate structure 250.

In Figs. 4a-b, the recesses 160 have been filled with one or more conformally deposited inner spacer materials. Examples of inner spacer materials include conformally deposited dielectric materials, e.g. as an oxide, a nitride or a carbide. In one example, a single inner spacer material (e.g. SiN) may be deposited to fill the recesses 160. In another example, a first inner spacer material (e.g. SiOC) may be deposited to partially fill the recesses 160 wherein a second inner spacer material (e.g. SiN) may be deposited to fill (by pinch-off) a remaining space in the recesses 160. The inner spacers 162 have been formed in the recesses 160 by subjecting the inner spacer material to an isotropic etching process to remove portions of the inner spacer material deposited outside the recesses 160. Any suitable isotropic etching process (wet or dry) for etching the dielectric material (e.g. SiN or SiN and SiOC) may be used. The etching may as shown be stopped when end surfaces of the channel layers of the device layer stack 110 are exposed and discrete portions of the inner spacer material remain in the recesses 160 to form the inner spacers 162

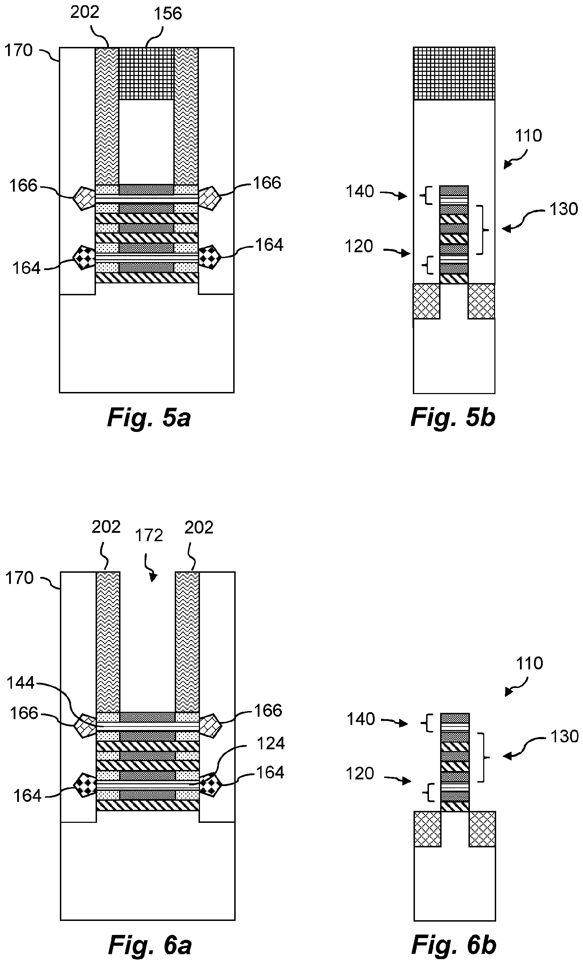

In Figs. 5a-b, source and drain regions 164 and 166 have been formed on the channel layers of the first sub-stack 120 and the third sub-stack 140, respectively. The source and drain regions 164, 166 have been formed by epitaxially growing semiconductor material on end surfaces of the channel layers exposed at opposite ends of the channel layers.

The source and drain regions 164 formed on the channel layer end surfaces of the first sub-stack 120 may be of a first conductivity type and the source and drain regions 166 formed on the channel layer end surfaces of the third sub-stack 140 may be of a second opposite conductive type. The first and second conductivity types may be a p-type and an n-type, or vice versa. The doping may be achieved by in-situ doping. Different conductivity types of the source and drain regions 164 and the source and drain regions 166 may be achieved by masking the channel layer end surfaces of the third sub-stack 140 while performing epitaxy on the channel layer end surfaces of the first sub-stack 120. The masking of the channel layer end surfaces of the third sub-stack may for example be provided by forming a temporary cover spacer along the third sub-stack. After completing the epitaxy of the source and drain regions 164, the temporary cover spacer may be removed and the source and drain regions 164 may be covered with one or more dielectric materials (e.g. ALD-deposited SiN and an inter-layer dielectric like SiO₂). Epitaxy may then be performed on the channel layer end surfaces of the third sub-stack 140. This is however merely one example and other process techniques facilitating forming of the source and drain regions 164, 166 with different conductivity types may also be used.

The source and drain regions 164, 166 may as shown subsequently be embedded in, or, encapsulated by an insulating layer 170. The insulating layer 170 may be formed of an insulating material, such as an oxide, e.g. SiO₂, or another inter-layer dielectric, deposited, planarized and recessed, e.g. by chemical mechanical polishing (CMP) and/or etch back. The CMP and/or etch back may proceed to also remove any capping 156 of the sacrificial gate structure 150. It is however also possible to stop the CMP and/or etch back on the capping 156 and subsequently open the capping using a separate etch step.

In Figs. 6a-b a gate trench 172 has been formed by removing the sacrificial gate body 250,152 between the opposite second dielectric material 202. Any conventional suitable etching process (isotropic or anisotropic, wet or dry) allowing selective removal of the sacrificial gate body 250,152 (e.g. of amorphous Si) may be used.

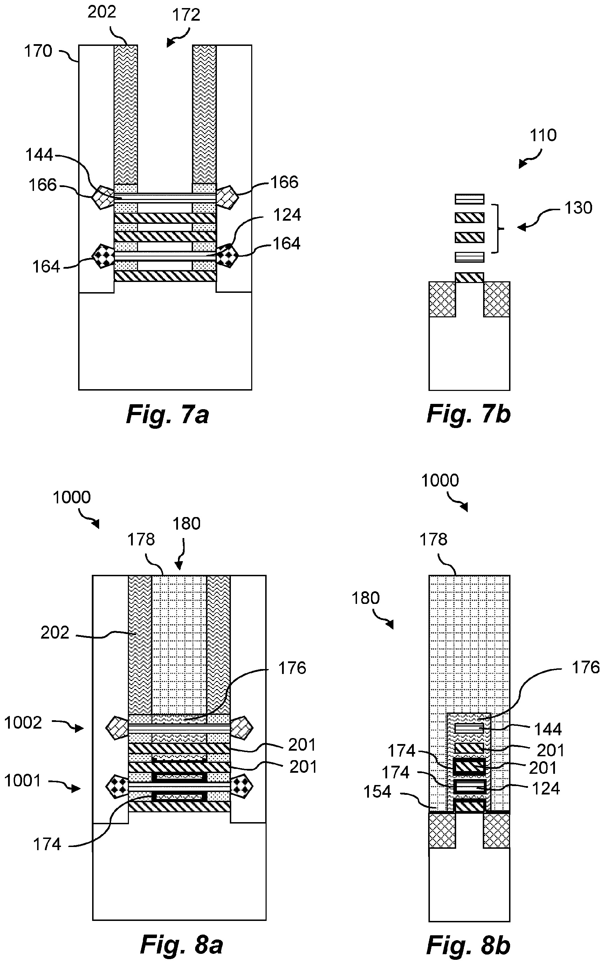

In Figs. 7a-b the first sacrificial layers of the device layer stack 110 have been removed by selectively etching the first sacrificial semiconductor material from the gate trench 172. A same type of etching process may be used for this step as during the forming of the recesses 160. By removing the first sacrificial layers, the channel layers of the device layer stack 110 may be released in the sense that upper and lower surfaces thereof may be exposed within the gate trench 172.

In Figs. 8a-b, a gate stack 180 has replaced the sacrificial gate body 152 and the first sacrificial layers.

The gate stack 180 comprises a gate dielectric layer (not shown); one or more work function metals, WFMs; and gate fill metal 178. In the following, a gate stack 180 comprising first 174 and second 176 WFMs will be described. At least two WFMs may be needed for a stack of FETs 1000 comprising both an NFET and a PFET. Figs. 8a-b, illustrate a stack of FETs 1000 comprising a first FET 1001 and a second FET 1002. In the illustration, one of the first 1001 and second 1002 FET is an NFET and the other is a PFET. Thus, the stack of FETs 1000 forms a CFET.

The gate dielectric layer may be conformally deposited in the gate trench 172 to conformally coat the channel layers. The gate dielectric layer may be formed of a conventional a high-k dielectric e.g. HfO₂, HfSiO, LaO, AlO or ZrO.

Subsequently, the first WFM 174 may be conformally deposited in the gate trench 172. The first WFM 174 may be formed of one or more effective WFMs (e.g. an n-type WFM such as TiAl or TiAlC and/or a p-type WFM such as TiN or TaN). The first WFM 174 may thus surround the channel layers of the first sub-stack 120.

Subsequently, the first WFM 174 may be removed from the channel layers of the third sub-stack 140, e.g. using a block mask as an etch mask. First WFM 174 surrounding the channel layers of the first sub-stack 120 may remain. The second WFM 176 may then be deposited on the gate dielectric surrounding the channel layers of the third sub-stack 140, and on portions of the first dielectric material 201. The second WFM 176 may thus surround the channel layers of the third sub-stack 140. The second WFM 176 may further surround the first WFM 174 of the first sub-stack 120.

The gate dielectric layer and/or the first WFM 174 and/or the second WFM 176 may be conformally deposited, e.g. by ALD.

Subsequently, a gate fill metal 178 (such as W, or Al) may be deposited to fill a remaining space of the gate trench 172. The gate fill metal 176 may for instance be deposited by CVD or PVD.

In the discussion above, a layer stack 110 without liner layers 133 has been used. However, liner layers 133 may advantageously be used. Accordingly, neighboring first 132a and second 132b sacrificial layers of the second sub-stack 130 may be separated by a liner layer 133, the liner layers 133 of the second sub-stack 130 being formed of a semiconductor material different from the first 201 and second 202 sacrificial semiconductor materials.

Fig. 9a-c illustrates the principle of liner layers 133.

Fig. 9a depict a cross-sectional view of a layer stack 110 comprising liner layers 133. The layer stack 110 comprises a first sub-stack 120, a second sub-stack 130 on the first sub-stack 120, and a third sub-stack 140 on the second sub-stack 130. The first 120 and third 140 sub-stack may be described analogously to the first 120 and third 140 sub-stack discussed in conjunction with Fig. 1a. The second sub-stack 130 may be described analogously to the second sub-stack 130 discussed in conjunction with Fig. 1a, but with the addition of liner layers 133 between neighboring first 132a and second 132b sacrificial layers of the second sub-stack 130. It may be said that each liner layer 133 may abut the respective first 132a and second 132b sacrificial layer that it separates.

Fig. 9b depicts the first sub-stack 120 (bottom), the second sub-stack 130 (middle) and the third sub-stack 140 (top) in isolation for illustrational clarity.

As mentioned, the liner layers 133 are formed of a semiconductor material different from the first and second semiconductor materials. For example, the channel material may be Si₁₋ₐGeₐ, the liner material may be Si_{1-b}Ge_{b}, the first sacrificial material may be Si_{1-c}Ge_{c}, and the second sacrificial material may be Si_{1-d}Ge_{d}, wherein 0 ≤ a ≤ b < c < d. For example, b may be in a range of 0-0.05. Further, c may be in a range of 0.1-0.25. Further, d may be in a range of 0.35-0.5. In a more specific example, the channel material may be Si (i.e. a = 0), the liner material may be Si (i.e. b = 0), the first sacrificial material may be Si_{0.75}Ge_{0.25}, and the second sacrificial material may be Sio.sGeo.s. These relative differences in Ge-content facilitate a selective processing (e.g. selective etching) of the different sacrificial layers, the liner layers 133, and the channel layers of the layer stack 110.

Liner layers 133 may be formed by epitaxial growth. Liner layers 133 may be formed with a thickness of 1-5 nm.

Fig. 9c depict a cross-sectional view of the layer stack 110 comprising liner layers 133 after removal of the second sacrificial layers 132b of the second sub-stack 130.

As further seen in Fig. 9c, the liner layers 133 may prevent rounding of the corners of the first sacrificial layers 132a of the second sub-stack 130. As the second sacrificial layers 132b of the second sub-stack 130 are etched, the etchant cannot attack the first sacrificial layers 132a via the cavities 135 formed due to the protective liner layers 133. Thus, the first sacrificial layers 132a of the second sub-stack 130 may only be attacked laterally via the recesses 160 of the second sub-stack 130.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A method for forming a semiconductor structure (100), the method comprising:
forming a layer stack (110) on a substrate (102), the layer stack comprising:
a first sub-stack (120) comprising a first sacrificial layer (122a) and on the first sacrificial layer (122a) a channel layer (124) defining a topmost layer of the first sub-stack (120);
a second sub-stack (130) on the first sub-stack (120) and comprising a plurality of sacrificial layers alternating between first (132a) and second (132b) sacrificial layers, wherein first sacrificial layers (132a) define a respective bottommost and topmost layer of the second sub-stack (130) , the second sub-stack comprising at least one second sacrificial layer (132b);
a third sub-stack (140) on the second sub-stack (130) and comprising a channel layer (144) defining a bottommost layer of the third sub-stack (140) and a first sacrificial layer (142a) on the channel layer (144);
wherein the first sacrificial layers are formed of a first sacrificial semiconductor material, the second sacrificial layers are formed of a second sacrificial semiconductor material different from the first sacrificial semiconductor material,
forming a gate structure (250) on the layer stack;
forming at least one cavity (135) by removing the at least one second sacrificial layer (132b) of the second sub-stack (130);
depositing a first dielectric material (201), wherein said act of depositing the first dielectric material (201) comprises filling the at least one cavity (135) with the first dielectric material (201);
providing a dielectric free gate surface, the dielectric free gate surface being an end surface (255) of the gate structure (250), free from the first dielectric material (201); and
depositing a second dielectric material (202) on the dielectric free gate surface, wherein the second dielectric material (202) is different from the first dielectric material (201);
wherein said act of depositing the second dielectric material (202) is performed after said act of depositing the first dielectric material (201).

2. The method according to claim 1, wherein the second dielectric material has a dielectric constant below 6.5.

3. The method according to claim 1 or 2, wherein the second dielectric material (202) comprises SiOCN and/or SiOC .

4. The method according to any one of the preceding claims, wherein the first dielectric material (201) is SiN, or SiOC or SiOCN or SiCN.

5. The method according to any one of the preceding claims,
wherein first dielectric material (201) is also deposited on the end surface (255) of the gate structure (250) during said act of filling the at least one cavity (135) with the first dielectric material (201); and
wherein said act of forming the dielectric free gate surface comprises removing first dielectric material (201) from the end surface (255) of the gate structure (250).

6. The method according to claim 5, wherein removing first dielectric material (201) from the end surface (255) of the gate structure (250) is performed by dry isotropic etching.

7. The method according to any one of the preceding claims, wherein said act of depositing the first dielectric material (201) is performed by a first chemical vapor deposition method, CVD method, the first CVD method comprising:
reacting, as a film-forming gas, an oxygen-containing silicon compound gas with a non-oxidizing hydrogen-containing gas in a state in which at least the non-oxidizing hydrogen-containing gas is plasmarized, to form a film of a flowable silanol compound; and
subsequently, annealing the film of flowable silanol compound into the first dielectric material,
wherein the oxygen-containing silicon compound gas comprises Si_{α}O_{β}(O-CₘHₙ)┌CₓH_{y}, wherein m, n, and α are integers of 1 or more; and wherein β, Γ, x, and y are integers of 0 or more; and β and Γ are not 0 at the same time.

8. The method according to any one of the preceding claims, wherein said act of depositing the second dielectric material (202) is performed by atomic layer deposition.

9. The method according to any one of the preceding claims, the method further comprising:
removing, by vertical recessing, ends of the layer stack (110) and second dielectric material (202) on said ends;
subsequently, laterally recessing end surfaces of the first sacrificial layers (122a, 132a, 142a) of the layer stack (110) to form recesses (160); and
forming inner spacers (162) in the recesses (160).

10. The method according to any of the preceding claims, wherein the second sub-stack (130) comprises at least two second sacrificial layers (132b), such that at least two cavities (135) are formed and filled with the first dielectric material (201).

11. The method according to any one of the preceding claims, wherein the gate structure (250) is a sacrificial gate body (152), the method further comprising
replacing the sacrificial gate body (152) with a gate stack (180).

12. The method according to claim 11, the method further comprising
forming source/drain regions (164) at opposite ends of the channel layer (124) of the first sub-stack (120); and
forming source/drain regions (166) at opposite ends of the channel layer (144) of the third sub-stack (140);
such that the semiconductor structure (100) forms a stack of field effect transistors, FETs, (1000) comprising:
a first FET (1001), comprising the channel layer (124) of the first sub-stack (120); and
a second FET (1002), comprising the channel layer (144) of the second sub-stack (140).

13. The method according to any one of the preceding claims, wherein neighboring first (132a) and second (132b) sacrificial layers of the second sub-stack (130) are separated by a liner layer (133), the liner layers (133) of the second sub-stack (130) being formed of a semiconductor material different from the first (201) and second (202) sacrificial semiconductor materials.

14. A semiconductor structure (100), comprising:
a layer stack (110), comprising:
a first sub-stack (120) comprising a first sacrificial layer (122a) and on the first sacrificial layer (122a) a channel layer (124) defining a topmost layer of the first sub-stack (120);
a second sub-stack (130) on the first sub-stack (120) and comprising a plurality of layers alternating between first sacrificial layer (132a) and layer of first dielectric material (201), wherein first sacrificial layers (132a) define a respective bottommost and topmost layer of the second sub-stack (130);
a third sub-stack (140) on the second sub-stack (130) and comprising a channel layer (144) defining a bottommost layer of the third sub-stack (140) and a first sacrificial layer (142a) on the channel layer (144);
wherein the first sacrificial layers (122a, 132a, 142a) are formed of a first sacrificial semiconductor material (201),;
a gate structure (250) arranged on the layer stack (110);
a second dielectric material (202) arranged on an end surface (255) of the gate structure (250);
wherein the second dielectric material (202) is different from the first dielectric material (201).

15. The semiconductor structure (100), according to claim 14,
wherein the second dielectric material (202) has a dielectric constant below 6.5
